# EUROPÄISCHE PATENTSCHRIFT

(11) **EP 3 259 604 B1**
(45) Veröffentlichungstag und Bekanntmachung des Hinweises auf die Patenterteilung: **23.01.2019**
(21) Anmeldenummer: 16711516.1
(22) Anmeldetag: 10.02.2016
(51) Int. Cl.: H01R 12/75, G01R 15/20, H01R 13/66

(54) **VORRICHTUNG ZUR INTEGRIERTEN STROMMESSUNG INNERHALB EINER HOCHVOLT-KONTAKTIERUNG EINES HYBRIDMODULS UND HYBRIDMODUL MIT DER VORRICHTUNG**
DEVICE FOR INTEGRATED CURRENT MEASUREMENT INSIDE A HIGH-VOLTAGE CONTACT OF A HYBRID MODULE, AND A HYBRID MODULE COMPRISING SAID DEVICE
DISPOSITIF POUR LA MESURE DE COURANT INTÉGRÉE DANS UN CONTACT HAUTE TENSION D'UN MODULE HYBRIDE ET MODULE HYBRIDE POURVU DUDIT DISPOSITIF

(30) Priorität: 16.02.2015 DE 102015202770
(43) Veröffentlichungstag der Anmeldung: 27.12.2017
(73) Patentinhaber: Schaeffler Technologies AG & Co. KG, 91074 Herzogenaurach (DE)
(72) Erfinder: BLAES, Cédric, 67470 Munchhausen (FR); LEONHARDT, Vincent, 67500 Haguenau (FR)
(86) Internationale Anmeldenummer: PCT/DE2016/200084
(87) Internationale Veröffentlichungsnummer: WO 2016/131455

(56) Entgegenhaltungen:
- JP-A- H1 097 879
- US-A1- 2008 094 060
- US-A1- 2013 214 593
- US-A1- 2014 357 126
- US-B1- 6 472 878

## Beschreibung

Die Erfindung betrifft eine Vorrichtung zur integrierten Strommessung innerhalb einer Hochvolt-Kontaktierung eines Hybridmoduls. Ferner betrifft die Erfindung ein Hybridmodul aufweisend die Vorrichtung.

Die Strommessung ist ein wesentlicher Teil eines Umrichters. In jedem Umrichter werden die Ströme von Motorphasen gemessen, um so eine Regelung zu legen. Aus dem Stand der Technik ist bekannt, die Strommessung mittels externer Stromsensoren durchzuführen. Der Wirkungsgrad eines Antriebs hängt von der Genauigkeit dieser Messung ab.

Nachteilig am Stand der Technik ist, dass sich die bekannten Stromsensoren nicht innerhalb einer Hochvolt-Kontaktierung integrieren lassen, da diese elektronischen Bauteile aufwendigen Bauraum und eine bestimmte Stromführung benötigen. Außerdem hängt die Genauigkeit der Strommessung von der Auslegung der Bauteile ab und es ist kaum möglich, eine hohe Genauigkeit über den gesamten Messbereich der Stromsensoren zu gewährleisten. Daher verschlechtert sich der Wirkungsgrad des Antriebs hauptsächlich bei kleineren Strömen.

Aus jeder der JP H10 97879 A und der US 2014/357126 A1 ist eine Vorrichtung bekannt, die ein Teil mit wenigstens einem auf dem Teil angeordneten Stromsensorchip und eine auf dem Teil aufgesetzte Hochvolt-Kontaktierungssteckverbindung aufweist. Die Hochvolt-Kontaktierungssteckverbindung weist mindestens einen Hall-Ring und eine durch den Hall-Ring geführte Stromschiene aufweist. Der Hall-Ring weist einen offen ausgebildeten Querschnitt auf und der Sensorchip ist zumindest teilweise in den offen ausgebildeten Querschnitt aufgenommen.

Bezüglich weiteren Standes der Technik wird auf die US 6 472 878 B1, die US 2008/094060 A1 und die US 2013/214593 A1 verwiesen.

Es besteht somit die technische Aufgabe, die Nachteile aus dem Stand der Technik zu überwinden. Es soll ein platzsparendes Konzept entwickelt werden, bei dem eine Strommessung innerhalb einer Hochvolt-Kontaktierung sehr präzise erfolgen kann.

Diese Aufgabe wird mit den in Anspruch 1 angegebenen Maßnahmen gelöst.

Weitere vorteilhafte Ausgestaltungen der vorliegenden Erfindung sind Gegenstand der abhängigen Ansprüche.

Eine Vorrichtung zur integrierten Strommessung innerhalb einer Hochvolt-Kontaktierung eines Hybridmoduls weist eine Leiterplatte mit wenigstens einem auf der Leiterplatte angeordneten Stromsensorchip und eine auf der Leiterplatte aufgesetzte Hochvolt-Kontaktierungssteckverbindung auf, wobei die Hochvolt-Kontaktierungssteckverbindung mindestens einen Hall-Ring und eine durch den Hall-Ring geführte Stromschiene aufweist, wobei der Hall-Ring einen offen ausgebildeten Querschnitt aufweist und der Sensorchip zumindest teilweise in den offen ausgebildeten Querschnitt aufgenommen ist.

Durch ein Vorsehen des Hallrings mit dem offen ausgebildeten Querschnitt zur Aufnahme des Sensorchips, ist eine integrierte Strommessung innerhalb der Hochvolt-Kontaktierung so kompakt wie möglich gestaltet. Damit kann eine Strommessung äußerst präzise erfolgen. Es sind sämtliche Spannungen und Strombereiche einfach messbar.

Vorzugsweise ist unter einem offenen ausgebildeten Querschnitt ein nicht geschlossener Querschnitt zu verstehen. Damit weist der Hall-Ring eine Unterbrechung seiner Ring-förmig durchgehenden Geometrie auf.

Bevorzugt funktioniert der Hall-Ring nach dem Prinzip des Hall-Effekts. Dabei beschreibt der Hall-Effekt das Auftreten einer elektrischen Spannung in einem stromdurchflossenen elektrischen Leiter, der sich in einem stationären Magnetfeld befindet. Die Spannung fällt dabei senkrecht sowohl zur Stromfluss- als auch zur Magnetfeldrichtung am Leiter ab und wird Hall-Spannung genannt. Der Hall-Effekt tritt damit in einem stromdurchflossenen Leiter auf, der sich in einem Magnetfeld befindet, wobei sich ein elektrisches Feld aufbaut, das zur Stromrichtung und zum Magnetfeld senkrecht steht und das die auf die Elektronen wirkende Lorentzkraft kompensiert. Bevorzugt besteht der Hall-Ring aus einem ferromagnetischen Material.

Vorzugsweise ist mittels des offen ausgebildeten Hall-Rings ein Open Loop Hall Effect erzeugbar. Durch das Vorsehen des Hall-Rings ist eine Optimierung der Strommessgenauigkeit erzielbar.

Bevorzugt ist der Sensorchip auf der Leiterplatte angelötet oder angeschweißt. Bevorzugt sind drei Stecker, drei Sensoren und drei Hall-Ringe für die Vorrichtung vorgesehen.

Bevorzugt ist die Vorrichtung als eine Kontaktierungsschnittstelle ausgebildet.

Vorzugsweise ist die Leiterplatte eine Platine. Bevorzugt ist die Leiterplatte ein vollintegriertes System, das der Ansteuerung eines Elektro-Motors und der Stromerzeugung dient.

Bevorzugt ist alternativ anstatt der Hochvolt-Kontaktierung auch eine 48 Volt-Kontaktierung vorsehbar. Entsprechend ist die Hochvolt-Kontaktierungssteckverbindung dann als 48 Volt-Kontaktierungssteckverbindung ausbildbar.

Ein erstes Ende der Stromschiene liegt an einem Stromversorgungselement an, das auf der Leiterplatte angeordnet ist.

Vorzugsweise ist das Stromversorgungselement auf der Leiterplatte angelötet oder angeschweißt. Bevorzugt ist das Stromversorgungselement eingerichtet Strom von einer Leistungselektronik über die Stromschiene zur Leiterplatte hin zum Elektro-Motor zu leiten.

Bevorzugt ist das Stromversorgungselement im Bereich des Stromsensorchips angeordnet.

Bevorzugt liegt das erste Ende der Stromschiene flächig, d.h. eben, an einer Seite des Stromversorgungselements an. Besonders bevorzugt bildet sich eine Kontaktfläche zwischen dem Stromversorgungselement und der Stromschiene aus.

Ddie Stromschiene weist ein zweites Ende auf, das mit einem Stecker verbunden ist.

Auf diese Weise ist eine Steckverbindung zu den AC-Phasen (den Statorstromschienen) des Elektro-Motors ausbildbar. Dies ermöglicht eine kompakte, schnelle und prozessgünstige Montage.

Das erste Ende der Stromschiene weist eine Öffnung auf und das Stromversorgungselement weist eine Öffnung auf.

Bevorzugt ist mindestens eine der Öffnungen als ein Langloch ausgebildet.

Durch das Vorsehen des Langlochs ist ein Höhenunterschied zwischen dem Stromversorgungselement der Leiterplatte und der Hochvolt-Kontaktierungssteckverbindung auf einfache Weise ausgleichbar. So lassen sich Toleranzen auf einfache Weise ausgleichen.

Ein Verbindungselement ist durch die Öffnung am Stromversorgungselement und durch die Öffnung des ersten Endes der Stromschiene zur Fixierung der Hochvolt-Kontaktierungssteckverbindung an der Leiterplatte geführt.

Damit ist ein Verbinden der Leiterplatte mit der Hochvolt-Kontaktierungssteckverbindung auf einfache Weise möglich.

Bevorzugt ist das Verbindungselement eine Schraube oder ein Niet.

Vorzugsweise ist das Verbindungselement eine Schraube, bevorzugt ein Stift oder Bolzen mit einem Außengewinde. Bevorzugt weisen die Öffnungen ein Innengewinde auf. Damit ist die Schraube auf einfache Weise in den Öffnungen verschraubbar.

Durch das Vorsehen eines Niets ist eine Fixierung des Verbindungselements an das erste Ende der Stromschiene schnell ausführbar.

Bevorzugt ist eine Schraubenmutter vorgesehen, die an einer dem Stromversorgungselement gegenüberliegenden Seite des ersten Endes der Stromschiene angeordnet ist, wobei das Verbindungselement als Schraube ausgeführt ist und durch die Öffnung des Stromversorgungselements und durch die Öffnung der Stromschiene geführt ist und mit der Schraubenmutter verschraubt ist.

Dabei wird die Schraube zunächst durch die Öffnung des Stromversorgungselements und dann durch die Öffnung der Stromschiene geführt, um im Anschluss daran mit der Schraubenmutter verschraubt zu werden.

Auf diese Weise ist ein Verbinden der Leiterplatte mit der Hochvolt-Kontaktierungssteckverbindung ebenfalls möglich.

Vorzugsweise weist die Schraubenmutter ein Innengewinde auf. Damit müssen die Öffnungen kein Innengewinde aufweisen. Bevorzugt ist die Schraubenmutter mit dem ersten Ende der Stromschiene verbunden. Besonders bevorzugt ist die Schraubenmutter am ersten Ende der Stromschiene angeschweißt.

Bevorzugt sind die Stromschiene und der Hall-Ring zumindest teilweise in einem Kunststoffgehäuse der Hochvolt-Kontaktierungssteckverbindung angeordnet.

Auf diese Weise lässt sich eine vor Schmutz- und Wassereintritt dichte Versiegelung erzeugen.

Ferner wird die Aufgabe erfindungsgemäß insbesondere gelöst durch ein Hybridmodul aufweisend eine Vorrichtung, wie oben beschrieben.

Vorzugsweise weist das Hybridmodul eine Leistungselektronik auf. Bevorzugt ist die Vorrichtung innerhalb der Leistungselektronik angeordnet.

Bevorzugt werden die Statorstromschienen über einen Steckvorgang mit den Steckern der Vorrichtung verbunden, um eine Strom- bzw. Spannungsübergabe an den Elektro-Motor des Hybridmoduls zu ermöglichen.

Die Erfindung wird nun beispielhaft durch Figuren veranschaulicht. Es zeigen:
**Fig. 1** eine schematische Ansicht einer erfindungsgemäßen Vorrichtung,
**Fig.2** eine schematische Ansicht einer integrierten Leistungselektronik und
**Fig. 3** eine schematische Ansicht eines erfindungsgemäßen Hybridmoduls.

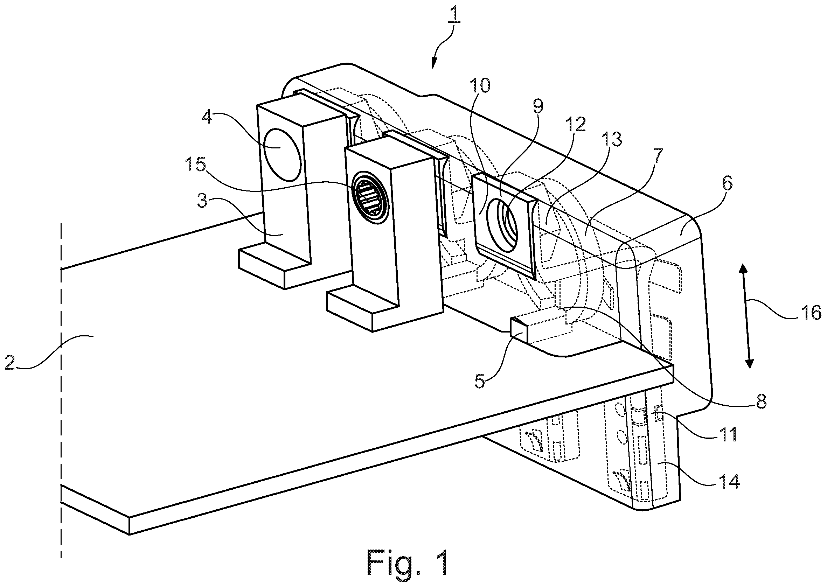

**Fig. 1** zeigt eine schematische Ansicht der erfindungsgemäßen Vorrichtung.

Die Vorrichtung 1 ist zur integrierten Strommessung innerhalb einer Hochvolt-Kontaktierung eines Hybridmoduls vorgesehen. Die Vorrichtung 1 weist eine Leiterplatte 2 auf, die als eine Platine ausgebildet ist. Auf der Leiterplatte 2 sind drei Stromsensorchips 5 angeordnet. Ferner weist die Vorrichtung 1 eine auf der Leiterplatte 2 aufgesetzte Hochvolt-Kontaktierungssteckverbindung 6 auf.
Die Hochvolt-Kontaktierungssteckverbindung 6 weist entsprechend der Anzahl an Stromsensorchips 5 drei Hall-Ringe 7 und jeweils eine durch die Hall-Ringe 7 geführte Stromschiene 9 auf. Die Hall-Ringe 7 weisen einen offen ausgebildeten Querschnitt 8 auf. Unter einem offenen ausgebildeten Querschnitt ein nicht geschlossener Querschnitt zu verstehen. Die Sensorchips 5 sind zumindest teilweise in den offen ausgebildeten Querschnitt 8 aufgenommen.

Die Hochvolt-Kontaktierungssteckverbindung 6 weist die drei Stromschienen 9 auf. Ein erstes Ende 10 jeder Stromschiene 9 liegt an einem Stromversorgungselement 3 an. Die Stromversorgungselemente 3 sind auf der Leiterplatte 2 im Bereich der Stromsensorchips 5 angeordnet. Die Stromversorgungselemente 3 sind auf der Leiterplatte 2 angeschweißt. Dabei liegt das erste Ende 10 der Stromschienen 9 flächig, d.h. eben, an einer Seite der Stromversorgungselemente 3 an.

Ferner weisen die Stromschienen 9 ein zweites Ende 11 auf. Die zweiten Enden 11 der Stromschienen 9 weisen Stecker 14 auf.

Die ersten Enden 10 der Stromschienen 9 weisen Öffnungen 12 auf. Die Stromversorgungselemente 3 weisen ebenfalls Öffnungen 4 auf. Die Öffnungen 4 der Stromversorgungselemente 3 sind als Langlöcher ausgebildet.

Ein auftretender Höhenunterschied zwischen dem Stromversorgungselement 3 auf der Leiterplatte 2 und der Hochvolt-Kontaktierungssteckverbindung 6 lässt sich nach einem erfolgten Aufsetzen der Hochvolt-Kontaktierungssteckverbindung 6 auf die Leiterplatte 2 einfach ausgleichen.

Im Bereich zwischen den ersten Enden 10 der Stromschienen 9 und den Hall-Ringen 7 sind Schraubenmuttern 13 angeordnet. Eine jede Schraubenmutter 13 ist an einer dem Stromversorgungselement 3 gegenüberliegenden Seite des ersten Endes 10 der Stromschiene 9 angeordnet

Um eine Fixierung der Leiterplatte 2 mit der Hochvolt-Kontaktierungssteckverbindung 6 zu erzeugen, sind Verbindungselemente vorgesehen, von denen lediglich ein Verbindungselement 15 in der Fig. 1 gezeigt ist.

Das Verbindungselement 15 wird zunächst durch die Öffnung 4 des Stromversorgungselements 3 und dann durch die Öffnung 12 der Stromschiene 9 geführt, um im Anschluss daran mit der Schraubenmutter 13 verschraubt zu werden. Dabei ist das Verbindungselement 15 als Schraube ausgeführt.

Die Stromschienen 2, die Hall-Ringe 7 und die Schraubenmuttern 13 sind zumindest teilweise in einem Kunststoffgehäuse der Hochvolt-Kontaktierungssteckverbindung 6 angeordnet. Auf diese Weise lässt sich eine vor Schmutz- und Wassereintritt dichte Versiegelung erzeugen.

Durch ein Vorsehen des Hallrings mit dem offen ausgebildeten Querschnitt zur Aufnahme des Sensorchips, ist eine integrierte Strommessung innerhalb der Hochvolt-Kontaktierung so kompakt wie möglich gestaltet. Damit kann eine Strommessung äußerst präzise erfolgen.

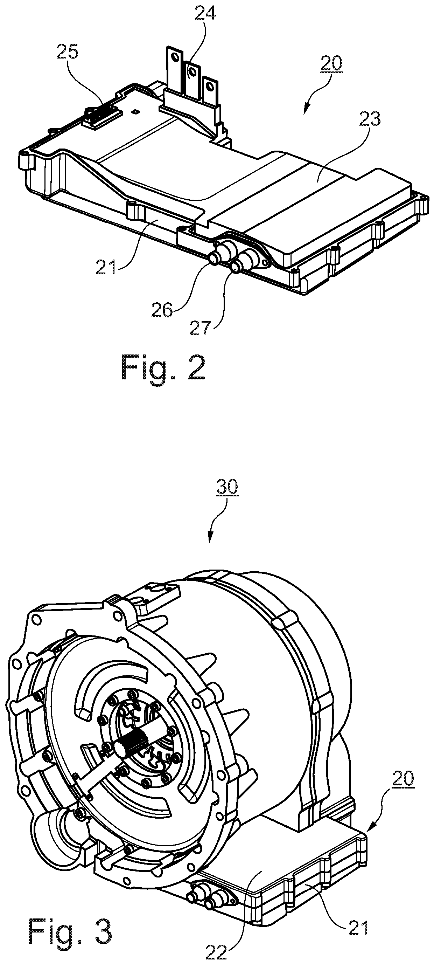

**Fig. 2** zeigt eine schematische Ansicht einer integrierten Leistungselektronik.

Die Leistungselektronik 20 weist ein Leistungselektronikgehäuseunterteil 21 auf, wobei Leistungsendstufenmodule (nicht dargestellt) im Leistungselektronikgehäuseunterteil 21 angeordnet sind. Ferner ist ein Kühldeckel 23 in das Leistungselektronikgehäuseunterteil 21 eingesetzt und auf die Leistungsendstufenmodule aufgesetzt. Im Leistungselektronikgehäuseunterteil 21 sind noch ein Kontrollmodul, ein Powerboard und eine Stromsensorik angeordnet (nicht dargestellt). Das Leistungselektronikgehäuseunterteil 14 weist Anschlüsse 26, 27 zur Kühlmittelzufuhr bzw. Abfuhr in den Kühldeckel 1 auf.

Ferner weist die Leistungselektronik 20 einen Sensorikanschluss 25 und drei Statorstromschienen 24 auf.

Die Leistungselektronik 20 weist die Vorrichtung 1 (nicht gezeigt), wie unter Fig. 1 beschrieben, auf. Die Statorstromschienen 24 werden mit der in der Leiterplatte 2 vorhandenen Kontaktierung über einen Steckvorgang mit den Steckern 14 der Vorrichtung 1 verbunden, um eine Strom- bzw. Spannungsübergabe an den Elektro-Motor eines Hybridmoduls zu ermöglichen.

**Fig. 3** zeigt eine schematische Ansicht eines erfindungsgemäßen Hybridmoduls.

Das Hybridmodul 30 weist die unter Fig. 2 gezeigte Leistungselektronik 20 mit der Vorrichtung 1 auf.

Die in das Leistungselektronikgehäuseunterteil 21 integrierte Leistungselektronik 20 gemäß Fig. 2 ist mittels des Leistungselektronikgehäuseoberteils 22 des Hybridmoduls 30 verschlossen.

### Bezugszeichenliste

- 1: Vorrichtung
- 2: Leiterplatte
- 3: Stromversorgungselement
- 4: Öffnung
- 5: Stromsensorchip
- 6: Hochvolt-Kontaktierungssteckverbindung
- 7: Hall-Ring
- 8: offener Querschnitt
- 9: Stromschiene
- 10: erstes Ende
- 11: zweites Ende
- 12: Öffnung
- 13: Schraubenmutter
- 14: Stecker
- 15: Befestigungsmittel
- 16: Richtung

- 20: Leistungselektronik
- 21: Leistungselektronikgehäuseunterteil
- 22: Leistungselektronikgehäuseunterteil
- 23: Kühldeckel
- 24: Statorstromschienen
- 25: Sensorikanschluss
- 26: Anschluss
- 27: Anschluss

- 30: Hybridmodul

## Patentansprüche

1. Vorrichtung (1) zur integrierten Strommessung innerhalb einer Hochvolt-Kontaktierung eines Hybridmoduls (30), wobei die Vorrichtung aufweist:
eine Leiterplatte (2) mit wenigstens einem auf der Leiterplatte (2) angeordneten Stromsensorchip (5) und
eine auf der Leiterplatte (2) aufgesetzte Hochvolt-Kontaktierungssteckverbindung (6), die mindestens einen einen offen ausgebildeten Querschnitt (8) aufweisenden Hall-Ring (7) und eine durch den Hall-Ring (7) geführte Stromschiene (9) aufweist, wobei
der Hall-Ring (7) und der Sensorchip (5) zumindest teilweise in den offen ausgebildeten Querschnitt (8) aufgenommen sind,
ein erstes Ende (10) der Stromschiene (9) an einem auf der Leiterplatte (2) angeordneten Stromversorgungselement (3) anliegt,
die Stromschiene (9) ein mit einem Stecker (14) verbundenes zweites Ende (11) aufweist,
das erste Ende (10) der Stromschiene (9) eine Öffnung (12) aufweist und das Stromversorgungselement (3) eine Öffnung (4) aufweist, und
ein Verbindungselement (15) durch die Öffnung (4) des Stromversorgungselements (3) und durch die Öffnung (12) des ersten Endes (10) der Stromschiene (9) zum Fixieren der Hochvolt-Kontaktierungssteckverbindung (6) an der Leiterplatte (2) geführt ist.

2. Vorrichtung (1) gemäß Anspruch 1, wobei mindestens eine der Öffnungen (4, 12) als ein Langloch ausgebildet ist.

3. Vorrichtung (1) gemäß Anspruch 1 oder 2, wobei das Verbindungselement (15) eine Schraube oder ein Niet ist.

4. Vorrichtung (1) gemäß einem der Ansprüche 1 bis 3, wobei
eine Schraubenmutter (13) vorgesehen ist, die an einer dem Stromversorgungselement (3) gegenüberliegenden Seite des ersten Endes (10) der Stromschiene (9) angeordnet ist, und
das Verbindungselement (15) als Schraube ausgeführt ist und durch die Öffnung (4) des Stromversorgungselements (3) und durch die Öffnung (12) der Stromschiene (9) geführt ist und mit der Schraubenmutter (13) verschraubt ist.

5. Vorrichtung (1) gemäß einem der Ansprüche 1 bis 4, wobei die Stromschiene (2) und der Hall-Ring (7) zumindest teilweise in einem Kunststoffgehäuse der Hochvolt-Kontaktierungssteckverbindung (6) angeordnet sind.

6. Hybridmodul (30), das eine Vorrichtung (1) gemäß einem der Ansprüche 1 bis 5 aufweist.

## Claims

1. Device (1) for integrated current measurement inside a high-voltage contact-making means of a hybrid module (30), wherein the device has:
a printed circuit board (2) with at least one current sensor chip (5) which is arranged on the printed circuit board (2), and
a high-voltage contact-making plug connection (6) which is mounted on the printed circuit board (2) and has at least one Hall ring (7) having an open cross section (8) and one busbar (9) which is passed through the Hall ring (7), wherein
the Hall ring (7) and the sensor chip (5) are at least partially accommodated in the open cross section (8),
a first end (10) of the busbar (9) bears against a current supply element (3) which is arranged on the printed circuit board (2),
the busbar (9) has a second end (11) which is connected to a plug (14),
the first end (10) of the busbar (9) has an opening (12) and the current supply element (3) has an opening (4), and
a connecting element (15) is passed through the opening (4) in the current supply element (3) and through the opening (12) in the first end (10) of the busbar (9) for the purpose of fixing the high-voltage contact-making plug connection (6) to the printed circuit board (2).

2. Device (1) according to Claim 1, wherein at least one of the openings (4, 12) is in the form of an elongate hole.

3. Device (1) according to Claim 1 or 2, wherein the connecting element (15) is a screw or a rivet.

4. Device (1) according to one of Claims 1 to 3, wherein a screw nut (13) is provided, which screw nut is arranged on a side of the first end (10) of the busbar (9) which is situated opposite the current supply element (3), and
the connecting element (15) is designed as a screw and is passed through the opening (4) in the current supply element (3) and through the opening (12) in the busbar (9) and is screwed to the screw nut (13)

5. Device (1) according to one of Claims 1 to 4, wherein the busbar (2) and the Hall ring (7) are at least partially arranged in a plastic housing of the high-voltage contact-making plug connection (6).

6. Hybrid module (30) which has a device (1) according to one of Claims 1 to 5.

## Revendications

1. Dispositif (1) pour la mesure de courant intégrée dans un système de contact haute tension d'un module hybride (30),
dans lequel l'appareil comporte :
une carte de circuit imprimé (2) comportant au moins une puce de capteur de courant (5) disposée sur la carte de circuit imprimé (2) et un connecteur de contact haute tension (6) monté sur la carte de circuit imprimé (2),
qui comporte au moins une bague de Hall (7) présentant une section transversale ouverte (8) et une barre omnibus (9) guidée à travers la bague de Hall (7),
dans lequel la bague de Hall (7) et la puce de capteur (5) sont au moins partiellement logées dans la section transversale ouverte (8),
une première extrémité (10) de la barre omnibus (9) est en appui sur un élément d'alimentation électrique (3) disposé sur la carte de circuit imprimé (2),
la barre omnibus (9) présente une deuxième extrémité (11) reliée à une fiche (14),
la première extrémité (10) de la barre omnibus (9) présente une ouverture (12) et l'élément d'alimentation électrique (3) présente une ouverture (4), et
un élément de liaison (15) est guidé à travers l'ouverture (4) de l'élément d'alimentation électrique (3) et à travers l'ouverture (12) de la première extrémité (10) de la barre omnibus (9) pour fixer le connecteur de contact haute tension (6) à la carte de circuit imprimé (2).

2. Dispositif (1) selon la revendication 1, dans lequel au moins l'une des ouvertures (4, 12) est réalisée sous la forme d'un trou allongé.

3. Dispositif (1) selon la revendication 1 ou 2, dans lequel l'élément de liaison (15) est une vis ou un rivet.

4. Dispositif (1) selon l'une des revendications 1 à 3, dans lequel
il est prévu un écrou (13) qui est disposé sur un côté de la première extrémité (10) de la barre omnibus (9) qui est opposé à l'élément d'alimentation électrique (3), et l'élément de liaison (15) est réalisé sous la forme d'une vis et est guidé à travers l'ouverture (4) de l'élément d'alimentation électrique (3) et à travers l'ouverture (12) de la barre omnibus (9) et est vissé à l'écrou (13).

5. Dispositif (1) selon l'une des revendications 1 à 4, dans lequel la barre omnibus (2) et la bague de Hall (7) sont disposées au moins partiellement dans un boîtier en matière plastique du connecteur de contact haute tension (6).

6. Module hybride (30) comprenant un dispositif (1) selon l'une des revendications 1 à 5.
